# EUROPEAN PATENT APPLICATION

(11) **EP 0 674 229 A1**
(43) Date of publication of application: **27.09.1995**
(21) Application number: 95300983.4
(22) Date of filing: 16.02.1995
(51) Int. Cl.: G03F 7/20, G03F 7/031

(54) **Polymeric composition and method for surface detackification**

(30) Priority: 18.02.1994 US 198460
(71) Applicant: Polyfibron Technologies, Inc., Atlanta, Georgia 30336-2293 (US)
(72) Inventor: Tsao, Jung-Hsien, Marietta, Georgia 30062 (US); Carter, Martin L., Marietta, Georgia 30060 (US); Kumpfmiller, Ronald J., Marietta, Georgia 30064 (US); Randall, Alvin V., East Point, Georgia 30344 (US)
(74) Representative: Jones, Helen Marjorie Meredith

(57) **Abstract**

Surface detackification of cured polymeric compositions is achieved by photoactivating a secondary photosensitive system which is incorporated into the composition prior to curing and which is activated after curing to minimize tack on the surface of the cured article. Preferred compositions contain a photocurable polymeric binder, such as a prepolymer, and first and second photosensitive systems or components which can be selectively activated at different times by using different wavelengths of curing radiation. The compositions and methods are particularly suited for making relief printing plates.

## Description

### BACKGROUND OF THE INVENTION

### Field of the Invention

This invention relates to a method for de-tackifying normally tacky polymer, resin, and rubber surfaces, and to a polymeric composition for use in such a method. More particularly, the invention relates to a method for reducing surface tack in printing plates made from photocurable polymeric compositions, and to compositions for carrying out the method.

### Related Art

Polymeric materials and articles sometimes have a problem of surface tackiness that may exist after curing. Canadian Patent No. 825,673 issued October 21, 1969, to W.R. Grace & Co., discloses a method for reducing surface tack of polymeric materials, wherein a rubber-based gasket material is exposed to ultraviolet (UV) light using a quartz lamp in the wave length range between 400 and 3200 A.(40-320 nanometers) to convert the tacky surface of the polymer to a "non-tacky skin film."

Surface tack is sometimes a problem in photocurable resin relief printing plates, which are used for commercial printing of newspapers, magazines, books, business forms, catalogs, labels, and the like. Photoresin relief printing plates also include flexographic printing plates which are used to print images or text onto corrugated box board for packaging of off-the-shelf consumer items. In photoresin relief printing plates, surface tack increases dust and lint pick-up, web pull and paper peeling, and stacking and storage difficulties, to name but a few of the problems.

Photoresin relief plates are generally prepared by imagewise exposing a photosensitive resin layer provided on a support to actinic rays through an image-bearing transparency, such as a negative film; washing out the unexposed (uncured) areas of the photosensitive resin layer with a developer (such as an organic solvent, an aqueous salt or alkaline solution, an aqueous solution of a surfactant, or water); and effecting post-exposure treatment to ensure completion of cross-linking, followed by drying. See e.g., Australian Patent AU-B-62273/90, incorporated by reference herein.

A variety of methods are known involving chemical or physical treatment to decrease surface tack of polymeric and photocurable polymeric materials. For photocurable materials in particular, these include methods in which relief images are treated with an oxidant, reducing agent, or the like; methods in which a coating material is applied onto the surface of the relief image; and methods in which the post-exposure of the relief images to actinic radiation is conducted in an inert gas or while dipping the relief images in a liquid so that oxygen does not inhibit the photocuring. See e.g., U.S. Patent 4,806,506. It is also known to add fatty acids or waxy materials which migrate to the surface of the polymer upon curing to decrease the suface tack.

U.S. Patent 4,400,459 of Gruetzmacher et al., also incorporated by reference herein, teaches a process for detackifying photosensitive elastomeric flexographic printing plates, wherein the developed, dried surface is, in either order, (1) post-exposed to actinic radiation, and (2) treated with a solution of an alkali monopersulfate and a bromide salt.

U.S. Patent 4,202,696 of Takahashi et al., also incorporated by reference herein, teaches a method of removing surface tack from photopolymer printing plates by impregnating the surface layer with an organic carbonyl compound capable of abstracting a hydrogen atom and then irradiating the plate with actinic radiation having wavelengths of 200 to 300 nm to excite the organic carbonyl compound.

U.S. Patent 4,716,094 to Minonishi et al., also incorporated by reference herein, teaches that a compound, such as a saturated or unsaturated carboxylic acid, amide, or alchohol, is incorporated into the photosensitive resin composition.

Published EP Application No. 0 017 927 to Nakamura et al. also incorporated by reference herein, teaches a process for detackification of photosensitive elastomeric printing plates, which have been developed or "washed out" with an organic solvent or mixture of solvents, e.g., perchloroethylene/n-butanol or trichloroethylene, by exposing to light having a wavelength not longer than 300 nm, e.g., with "germicidal" lamps.

U.S. Patent 4,806,506, to Gibson, Jr., also incorporated by reference herein, teaches a process for detackifying an imagewise exposed and solvent-developed flexographic relief printing plate. The process comprises the steps of drying the plate after development, applying an aprotic solvent to the surface of the plate, and subsequently exposing the printing surface to radiation with wavelengths in the range of 200-300 nm. The process also involves exposing the printing surface to wavelengths longer than 300 nm at a point subsequent, simultaneous, or prior to using the 200-300 nm wavelengths.

Accordingly, the present invention relates to an improved method and composition for detackifying polymeric materials, and, in particular, photocurable polymer relief printing plates.

### SUMMARY OF THE INVENTION

The present invention provides an improved method and composition for decreasing surface tack in polymeric materials.

One purpose of the invention is to obtain effective and convenient surface detackification of polymeric articles, including relief printing plates.

Another purpose is to achieve surface detackification without the necessity of having to add fatty acids or waxy substances and thus having to use a non-homogenous polymeric composition.

Another purpose is avoid the necessity of having to spray or coat the surface of a developed polymeric article, such as a relief printing plate, with an externally applied chemical solution, or to dip the plate into a chemical solution, in contrast to the prior art method disclosed, for example, in U.S. Patent 4,202,696.

Yet another purpose of the invention is to provide a method for making a polymeric article, such as a relief printing plate, which involves post-development treatment using radiation having wavelengths of 200-300 nm. Exemplary polymeric compositions of the invention comprise a secondary photosensitive system for achieving surface detackification. This "secondary" photosensitive system is so called because it is fully incorporated into the polymeric composition, prior to initial (or primary) curing or cross-linking of the composition, and further because it is thereafter exposed to radiation wavelengths in the range of 200-300 nm to initiate surface treatment. The incorporation of the secondary photosensitive system into the polymer composition in a homogeneous manner helps to ensure that the photosensitive materials are present in effective and uniform concentrations at the exposed surface of the cured article.

The composition of the invention comprises a photocurable polymeric binder, a first photosensitive system homogenously mixed with the binder, and a second photosensitive system homogenously mixed with the binder.

Preferably, the polymeric binder comprises a prepolymer containing groups which polymerise upon photoactivation of the first photosensitive system. The prepolymer is, for instance a urethane prepolymer. The prepolymer suitably has a number average molecular weight of at least 2000. The polymerisable group of the prepolymer is usually an ethylenically unsaturated group capable of addition polymerisation upon initiator by photoactivated photosensitive system.

The composition preferably contains, in addition to prepolymer, polymerisable diluent, such as copolymerisable comonomer which copolymerises with the prepolymer upon photoactivation of the first photo sensitive system. Such comonomer is, for instance, an ethylenically unsaturated compound, such as an acrylate compound. The comonomer may include poly- and/or mono-unsaturated compounds.

The two photosensitive systems of components each are characterised by an ultraviolet UV radiation absorption spectrum which are such that the two components can be selectively photoactivated by using different UV radiation wavelengths. The first photosensitive system preferably comprises a compound operative to cure the polymeric binder by radical polymerisation upon exposure to radiation having wavelengths of at least 300 nanometres (but which may not be activated by radiation having wavelengths in the range 200 to 300 nm). Preferably the system contains a benzoin alkyl ether carbonyl compound. Preferably the compound is operative to undergo a Norrish type I reaction through homolytic alpha-cleavage reaction between a carbonyl group and an adjacent carbon atom.

The second photosensitive system preferably comprises a compound operative to cure the polymeric binder by radical polymerisation upon exposure to radiation having wavelengths in the range 200-300 nm (but which is not activated by radiation having wavelengths of greater than 300 nm. More preferably it comprises an amine, preferably photosensitive component operative to reduce surface tack of the cured article when exposed to radiation having wavelengths in the range 200 to 300 nm; and exposing the surface of said cured polymeric article to radiation having wavelengths in the range 200 to 300 nm.

Preferably in the method the step of providing a cured polymeric article comprises the steps of
combining into a homogenous mixture a photocurable polymeric binder, a first photosensitive system and a second photosensitive system homogenously first and second photosensitive systems comprising photoinitiators which are operative the first and second photosensitive systems having ultraviolet (UV) radiation absorption spectrums which are such that the two systems can be selectively photoactivated by using different UV radiation wavelengths; and
curing the mixture by exposing the mixture to radiation to activate the first photosensitive system.

The invention is of particular applicability to aqueous developable composition. A preferred method accordingly covers a process including the steps of imagewise exposure of the homogenous mixture to radiation capable of activating the first photosensitive system and removal of uncured mixture using a developer, preferably an aqueous developer. The process may involve other steps in which the cured polymer is contacted with water. In such processes it is found to be preferable to remove water from the surface of the article prior to the exposure to wavelength 200 to 300 nm.

Further features and advantages of the invention are described further hereinafter.

### BRIEF DESCRIPTION OF THE DRAWING

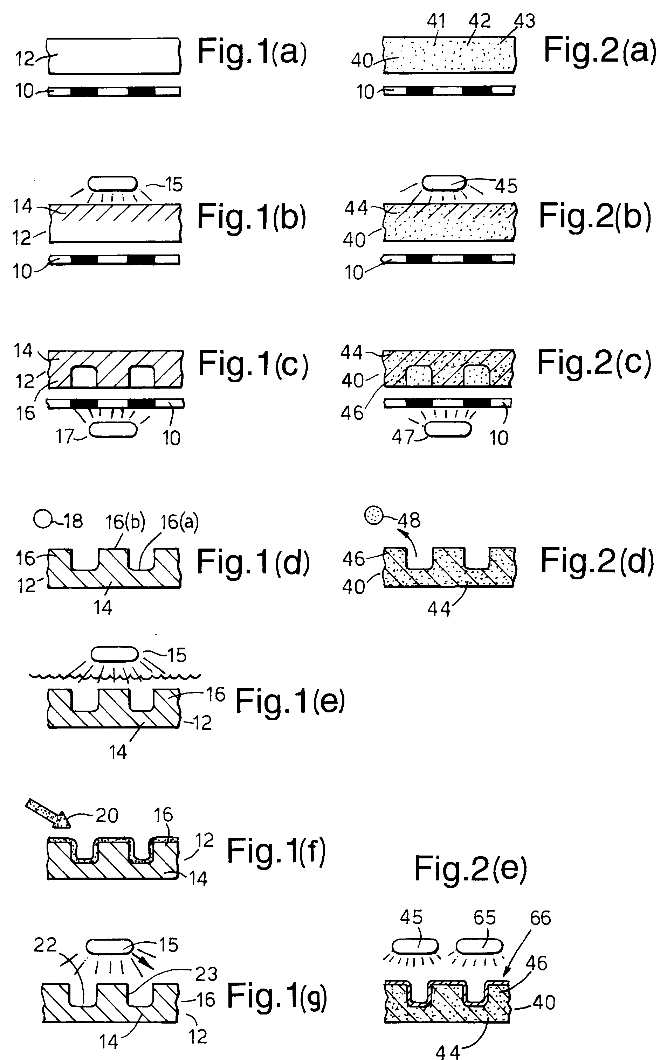

Fig. 1 is an illustration of a method for making photopolymeric relief printing plates (shown in partial cross-sectional exploded view) of the prior art; and

Further features and advantages of the invention are described further hereinafter.

### BRIEF DESCRIPTION OF THE DRAWING

Fig. 1 is an illustration of a method for making photopolymeric relief printing plates (shown in partial cross-sectional exploded view) of the prior art; and
Fig. 2 is an illustration of an exemplary method of the invention for making photopolymeric relief printing plates of the invention.

### DETAILED DESCRIPTION OF THE INVENTION

An illustration of a prior art method for making a photopolymeric relief printing plate, including steps for detackifying the plate, is provided in Fig. 1 for comparative purposes. The illustrated prior art method is presented in accordance with U.S. Patent 4,202,696 issued May 13, 1980, to Takahashi et al., mentioned above.

According to US 4,202,696, as illustrated in Fig. 1(a), a photosensitive resin composition 12 is provided by coating a mixture containing polymeric binder and a photoinitiator onto a transparent polyester cover film (not shown). The coating 12 is covered with transparent polypropylene film (not shown). For purposes of discussion herein, the composition 12 is shown positioned over an image-containing negative 10. Thus, in Fig. 1(b), the top of the composition is cured to form a floor 14 in the back of the plate 12 by exposure to light radiation 15. In Fig. 1(c), the relief image is formed by imagewise exposing the bottom of the plate 12 to actinic radiation 17, ie. through the image-bearing negative 10. As illustrated in Fig. 1(d), uncured polymer material 18 is removed from the plate 12 such as by washing with an aqueous solution to obtain the relief image 16, which has concave portions 16(a) and convex portions 16(b). According to customary practice, the plate is then immersed in water as shown in Fig. 1(e), exposed for 10-20 minutes to actinic radiation 15, removed from water bath, and dried. Subsequently, the printing relief surface 16 is surface impregnated with an organic carbonyl compound, as shown in Fig. 1(f) and designated at 20, by spraying or coating the relief surface 16 with a solution containing the compound, or by dipping the surface 16 into the solution. Thereafter, the surface treated plate 12 is exposed to radiation 15 having wavelengths in the range of 200-300 nm. whereby a tack-free surface is said to be obtained (See Fig. 1(g).

The present inventors have discovered that treatment methods which require post-development external application of chemicals present a number of difficulties. Photopolymer relief printing plates are often manufactured in dimensions of approximately 30 x 40 inches or larger, a size which makes handling during processing and treatment difficult. It is believed that post-development surface spraying, coating, or dipping does not guarantee that the active surface ingredient is present in an effective or uniform concentration at the surface of the cured printing plate or article to be treated. For example, it is believed that a disproportionate amount of treatment agent may be collected in the concave 16(a) portions of the relief surface 16; whereas the convex 16(b) portions as well as the shoulder portions joining portions 16(a) and 16(b) may, especially in the case of spraying or coating, have a deficient concentration of the active ingredient due to run-off. It is also possible, where the entire plate 12 is dipped into solution, that air bubbles would form and thereby avoid surface impregnation at certain points by the treatment solution. Moreover, a major concern is that the active ingredient (the organic carbonyl compound) may not be in sufficient concentration in the treatment solution.

In surmounting the disadvantages of the prior art, the present invention provides a composition and method for forming polymeric articles and relief printing plates having tack-free surfaces.

The concept of reducing surface tack, or of obtaining a "tack-free" surface, as used in this invention, refers more than just to the state in which the stickiness of the cured polymeric article is decreased or avoided. In photocurable relief printing plates, a plate which has been developed, washed to remove uncured polymer, post-exposed under water, and dried, such as by using an oven, may be considered initially to have little or no tack on the surface. However, it has been found that after wiping alcohol onto the dried surface, in emulation of the effect of contact with alcohol-containing inks, the surface can consequently become tacky to the touch. Therefore, the concept of surface detackification, as contemplated in the present invention, involves a permanent post-development state of decreased surface stickiness.

Exemplary polymeric compositions of the present invention preferably comprise a photocurable polymeric binder and first and second photosensitive systems which are dissolved into the binder composition. Accordingly, the compositions of the invention are deemed "homogenous" in that the binder and photosensitive components are preferably compatible and do not separate into discrete layers or domains either before or after primary curing of the binder, as would be the case with some fatty acids (e.g., myristic acid) or waxes.

Known polymeric binders, preferably having a number average molecular weight of at least 1000, more preferably of at least 2000, and most preferably of at least 3000, can be used within the contemplation of this invention. These include polymerizable ethylenically unsaturated monomers and/or oligomers containing at least one polymerizable ethylenically unsaturated carbon-carbon double bond, as well as natural and synthetic rubber materials. Some polymeric binders believed to be particularly suitable for use in the invention are described in U.S. Patents 3,759,807 and 4,139,436; and in Australian Patent AU-B-62273/90 published May 23, 1991, all incorporated by reference herein. For relief printing plates, exemplary polymeric binders are urethane-based, and more preferably are formed from an isocyanate terminated polyether urethane prepolymer and an ethylenically unsaturated more hydroxy alcohol preferably an acrylate compound.

Prefered photocurable polymeric compositions 40 of the invention, such as shown in Fig. 2(a) incorporate a polymer binder 41, and primary 42 and secondary 43 photosensitive systems while are dissolved within the binder composition 40 prior to primary curing thereof. The purpose of incorporating the additional, "secondary" photosensitive system 43 within the composition 40, as summarized previously, is to have a photoactivatable system which is uniformly present within the photocurable resin composition 40 and which is not substantially activated during initial curing, so as to guarantee that it is present in effective and uniform concentrations at the surface of the cured material (e.g, over the concave, convex, and shoulder areas of a relief printing plate) and capable of being activated by germicidal lamps (200-300 nm) after primary cure of the polymer system. The secondary photosensitive system 43 therefore should comprise components which are not substantially activated by the conditions which activate or photoactivate the primary photosensitive system 42.

Indeed, it is believed that in other exemplary embodiments of the invention, a thermally activated catalyst or one which, for example, can be activated by electron beam irradiation, can be substituted for the primary photosensitive system 42 for the purpose of primary curing or polymerizing the polymer binder 41.

Exemplary primary photosensitive systems 41 for incorporation with the binder 41 into the composition 40 comprise a benzoin alkyl ether carbonyl compound operative to cure the binder by radical polymerization upon exposure to radiation having wavelengths of at least 300 nanometers or greater.

The term "curing" as used in the present invention, is intended to refer to curing or polymerization of the binder throughout the body volume of the polymer composition. In relief printing plates, for example, the curing initiated by the primary photosensitive component 42 should preferably result in a "deep cure" whereby polymeric binder 41 located innermost within the thickness of the sheet is cured along with polymeric binder that is located at the floor 44 and relief sides 46 of the cured sheet 40. Such primary photosensitive compounds may be selected from known carbonyl compounds, such as ones described in U.S. Patent 3,759,807, incorporated by reference herein. A preferred photosensitive component 42 system, is 2,2-dimethoxy-2-phenyl-acetophenone.

Exemplary secondary photosensitive systems 43 or compounds incorporated into compositions 40 of the invention preferably comprise a carbonyl compound operative to abstract hydrogen when exposed to radiation having wavelengths in the range of 200-300 nm. Preferably, so-called "germicidal lamps" are suitable for such a purpose. A preferred secondary photosensitive system 43 comprises a mixture comprising a benzophenone, preferably having the formula O=C(R)₂ wherein R is a substituted or an unsubstituted phenyl ring, and an amine, preferably a tertiary amine. The use of benzophenone, wherein the phenyl rings are unsubstituted, is preferred. Although the benzophenone/amine combination is known for use as a principle photoinitiator, the present inventors believe that it has not been previously known or suggested to use the combination as a secondary photosensitive system for post-development surface detackification, as taught by the present invention. Further exemplary embodiments involve the use of a benzophenone having substituted groups on one or more phenyl ring.

As shown in Fig. 2(a), exemplary photocurable polymeric compositions 40 comprising the above described binder 41, first photoactivatable system 42, and second photoactivatable system 43 (indicated by dot-shading in Figs. 2(a)-(e)), are applied over a cover film (not shown), that was vacuumed down onto the lower glass plate of a commerical exposure unit (not shown). An image-bearing negative 10 is shown located beneath the lower glass plate. A polyester backing sheet (not shown) is laminated onto the composition 40 using a roller. In Fig. 2(b), the top of composition 40 laminate is exposed to actinic radiation 45 having wavelengths of at least 300 nm or greater, whereby the benzoin ether primary photoinitiator 42 principally undergoes Norrish type I cleavage to form radicals that initiate the polymerization process, and the plate floor 44 is formed. In Fig. 2(c), the bottom of the plate 40 is imagewise exposed similarly with actinic radiation 47 having wavelengths of at least 300 nm or greater, whereby the relief image 46 is formed. In Fig. 2(d), the plate 40 is removed from the exposure unit, and preferably placed into a hot air blade unit (not shown) in which uncured polymer material 48 is removed from the relief image 46. The plate 40 is then preferably placed into a rotary washout unit where it is spray washed with an aqueous detergent solution for 10 minutes to remove any residual uncured polymer. Optionally, the plate 40 may be placed into water and subjected to post-development exposure to actinic radiation similar to the prior art step shown in Fig. 1(e). The plate is then dried preferably by using a paper towel.

As shown in Fig. 2(e), the developed relief printing plate 40 is then exposed under a germicidal lamp 65 using wavelengths of 200-300 nm to activate the secondary photosensitive system 43 that is present at the relief surface 46. In preferred methods, the relief plate 40 is also post-exposed to radiation having wavelengths of 300-400, as illustrated by the lamp shown at 45 in Fig. 2(e). Post-development use of the optional lamp 45 ensures "deep curing" of the entire plate layer. Alternatively, a single radiation source can be used to emit radiation having wavelengths in the range of 200-300 nm as well as in the range of 300-400 nm. Preferably, before use, the plate is oven-dried to ensure that all moisture is removed.

In preferred methods, the post-developed relief plate 40 shown in Fig. 2(e) is cured with a germicidal lamp 65 to the extent that a "skin" 66 is formed over the relief surface 46. Accordingly, exemplary compositions of the invention are claimed in which the composition is formed into a relief printing plate, and indeed into a relief plate having a tack-free skin 66 over the relief printing surface 46. Accordingly, the present invention is also directed to relief printing plates formed from a binder composition 40, first and second photosensitive systems 42 and 43, one of which is incorporated into the binder before primary curing and thereby operative to form a skin 66 when exposed to radiation having wavelengths in the range of 200-300 nm.

In particularly preferred methods, the developed relief printing plate is dried, such as by using a blotter or paper towel, prior to exposure under a germicidal lamp. Accordingly, it has been found that prior to the post-development exposure under germicidal lamps (200-300 nm), it is preferable to remove water and moisture from the relief surface, such as by blotting using a paper towel. The post-development step (shown in Fig. 2(e)) should preferably be performed in dry conditions, preferably in ambient air; or it can be performed in an inert gas atmosphere or under a transparent sheet.

In further exemplary compositions and methods, the exemplary composition 40 comprises a polymeric binder 41 having at least 2000 ave. mw; a first photosensitive component 42 which undergoes a Norrish type I reaction through homolytic alpha cleavage reaction between a carbonyl group and an adjacent carbon atom; and a second photosensitive component 43 which undergoes a Norrish type II reaction through hydrogen abstraction.

The following examples are provided for illustrative-purposes only and are not intended to limit the scope of the present invention. Proportions are given in terms of percentage total solids weight except where otherwise indicated.

### REFERENTIAL EXAMPLE 1

To a resin kettle were charged 100 parts polypropylene glycol diol having a number average molecular weight of about 3,000; and 100 parts of an ethylene oxide-propylene oxide block polyether diol having a number average molecular weight of about 2,000 and about 45% by weight of ethylene oxide terminal units. The two polyols were reacted with 18 parts of a mixture of 2,4-toluene diisocyanate/2,6-toluene diisocyanate (80/20 by weight) in the presence of 0.11 parts dibutyltin dilaurate at 75°C for 2 hours.

The resulting isocyanate terminated polyurethane was further reacted with 19 parts polypropylene glycol monomethacrylate with a number average molecular weight of 350-380 at 75°C until all of the isocyanate is consumed as determined by IR spectroscopy and the disappearance of the peak at 2600 cm⁻¹.

To 100 parts of the prepolymer was added 0.08 parts 2,6-di-t-butyl-4-methylphenol as a free radical inhibitor, 1.01 parts benzophenone, 0.78 parts 2,2-dimethoxy-2-phenyl-acetophenone as a curing agent, 3.03 parts diethylaminoethyl methacrylate, 4.27 parts diethylene glycol dimethacrylate, and 46.1 parts polypropylene glycol monomethacrylate with a number average molecular weight of about 350-380 to produce a photosenstive resin composition.

### EXAMPLE 1

A relief printing plate was produced from the photosensitive resin composition obtained in Referential Example 1 by the following process: a photographic negative was placed on the lower glass plate of a commercial exposure unit, Grace 3048 system, and covered with a 20µ polypropylene protective film which was subsequently vacuumed down to remove any wrinkles or air pockets. The resin was applied to the cover film to a depth of 0.25 inch (6 mm) with the aid of a containment dam, and to the composition was laminated a polyester backing sheet by the roll laminator on the machine. After lowering the top glass, the composition was first given a back exposure through the top polyester backing using actinic lamps (Phillips 80W/10R) with an intensity of 3.7 mW/cm² and a wavelength of 300-400 nm for 75 seconds to create the plate floor and subsequently exposed imagewise through the negative using actinic lamps (Phillips 80W/10R) with an intensity of 9.0 mW/cm² and a wavelength of 300-400 nm for 300 seconds to cure the image. The polypropylene cover film was removed and the plate placed in a hot air knife unit to remove any uncured polymer and subsequently placed in a rotary washout unit where the plate was sprayed with an aqueous detergent solution for 10 minutes to remove any residual uncured polymer. The plate was rinsed and further post-cured for 10 minutes in the post-exposure unit equipped with fluorescent black lamps (approximately 5-10 mW/cm² and 300-400 nm) and containing water in which was dissolved sodium sulfite as an oxygen scavenger.

The plate was rinsed and put in a drying oven at approximately 40°C for 30 minutes at which time it was removed and allowed to cool. To simulate the tackifying effect of alcohol-based inks, (which tend to induce tackiness when introduced to the cured plate), the relief plate was contacted by alcohol, dried, and the level of surface tack was thereafter measured. The plate was wiped 20 times with 30% (by volume) isopropanol (IPA) in water, allowed to stand for 15 seconds, and blotted dry. The tack was determined by pressing a clean piece of polyethylene terephthalate film onto the sample area and determining the amount of resistance to removing the film. This measurement was determined at 1 minute and 1 hour after blotting the sample. The plate produced in this example was tack free before the test but became extremely tacky after this test was conducted.

### EXAMPLE 2

In the same manner as described in Example 1, a relief printing plate from the photosensitive resin composition obtained in Referential Example 1 was produced. After the plate was dried it was exposed to germicidal radiation (200-300 nm at a distance of 4-5 inches (100-130 mm) in an air atmosphere for 10 minutes), and the same tack test described in Example 1 was used to determine the tack of the plate. The plate was determined to be tack free both before and after the tack test described in Example 1 was conducted.

### EXAMPLE 3

Utilizing the same method as described in Example 1, a relief printing plate from the photosensitive resin composition obtained in Referential Example 1 was produced, but after the plate was washed in the rotary washout it was dried in a 40°C oven and subsequently exposed simultaneously for 10 minutes in an air atmosphere to fluorescent black lamps (approximately 5-10 mW/cm² and 300-400 nm) and germicidal radiation (200-300 nm) placed perpendicularly to and just under the fluorescent lamp in a crosswise manner. The same tack test described in Example 1 was used to determine the tack of the plate. The plate was determined to be free from surface tack both before and after the tack test described in Example 1 was conducted.

Table 1 summarizes the foregoing examples 1-3.

**TABLE 1**

| **(Post-development Conditions and Results)** | | | | | |
|---|---|---|---|---|---|
| | | | **Tack after 30% IPA Wash** | | |
| **Example No.** | **Medium** | **Source** | **Time (min)** | **1 min.** | **1 hr.** |
| 1 | water/salt | A | 10 | 5 | 5 |
| 2 | water/salt | A | 10 | | |
| | (air) | G | 10 | 2 | 2 |
| 3 | (air) | A + G | 10 | 2 | 2 |

The salt used was sodium sulfite
A = Actinic radiation (300-400 nm)
G = Germicidal radiation (200-300 nm)
A + G = both radiation sources at the same time
1 = No Tack
2 = Little Tack
3 = Moderate Tack
4 = Excessive Tack
5 = Extreme Tack

### EXAMPLE 4

The photosensitive resin composition obtained in Example 1 was cured by the following process: the lower glass plate of a commercial exposure unit, Grace 3048 system, was covered with a 20 um polypropylene protective film which was subsequently vacuumed down to remove any wrinkles or air pockets. The resin was applied to the cover film to a depth of 0.25 inch (6 mm) with the aid of a containment dam, and to the composition was laminated a polyester backing sheet by the roll laminator on the machine. After lowering the top glass, the composition was first given a back exposure through the top polyester backing using actinic lamps with an intensity of 3.7 mW/cm² and a wavelength of 300-400 nm for 75 seconds and subsequently exposed through the bottom cover film using actinic lamps with an intensity of 9.0 mW/cm² and a wavelength of 300-400 nm for 300 seconds. The polypropylene cover film was removed. The solid plate had a tacky surface and the plate was further post-cured for 10 minutes in an air atmosphere to fluorescent black lamps (approximately 5-10 mW/cm² and 300-400 nm) and simultaneously to germicidal radiation (200-300nm) placed perpendicularly to and just under the fluorescent lamp in a crosswise manner. The plate was determined to be free from surface tack both before and after the tack test described in Example 1 was conducted.

### EXAMPLE 5

Utilizing the same method as described in Example 4, a solid plate was produced. After stripping off the polypropylene cover film, the solid plate had a tacky surface and was first exposed for 10 minutes in air under fluorescent black lamps followed by another 10 minutes in air under germicidal lamps described. The plate thus obtained was determined to be free from surface tack both before and after the tack test described in Example 1 was conducted.

### EXAMPLE 6

Utilizing the same method as described in example 4, a solid plate was produced. It was then exposed for 10 minutes under the fluorescent black lamps and the germicidal lamps simultaneously as described in example 4 without removing the polypropylene cover film. Thereafter, the cover film was removed and the cured solid plate was determined to be free of surface tack both before and after the tack test described in Example 1 was conducted.

### COMPARATIVE EXAMPLE 1

In the same manner as described in Referential Example 1, a photocurable resin was produced with the omission of the benzophenone and the diethlyaminoethyl methacrylate in the formulation. A solid plate was produced as described in Example 4, but the plate produced was extremely tacky both before and after the tack test described in Example 1 was conducted.

### COMPARATIVE EXAMPLE 2

In the same manner as described in Referential Example 1, a photocurable resin was produced with the omission of the benzophenone and the diethylaminoethyl methacrylate in the formulation. A solid plate was produced as described in Example 5, but the plate produced was extremely tacky both before and after the tack test described in Example 1 was conducted.

### COMPARATIVE EXAMPLE 3

In the same manner as described in Referential Example 1, a photocurable resin was produced with the omission of the benzophenone and the diethylaminoethyl methacrylate in the formulation. A solid plate was produced as described in Example 6, but the plate produced was extremely tacky both before and after the tack test described in Example 1 was conducted.

The foregoing explanations and illustrations are provided for illustrative purposes only, and are not intended to limit the scope of the invention.

## Claims

1. A photocurable composition comprising:
a photocurable polymeric binder, a first photosensitive system homogenously mixed with the binder, and a second photosensitive system homogenously mixed with the binder; the first and second photosensitive systems having ultraviolet (UV) radiation absorption spectrums which are such that the two systems can be selectively photoactivated by using different UV radiation wavelengths, thereby permitting the first photosensitive system to cure the polymeric binder, and permitting the second photosensitive system to be photoactivated at the surface of the cured material, but which is inactivable by radiation having wavelength of greater than 300 nm.

2. A composition according to claim 1 in which the first photosensitive system is activated by radiation have wavelengths of 300 nm or greater, but which is inactivable by radiation having wavelengths less than 300 nm and the second photosensitive system is activable by radiation having wavelength in the range 200 to 300 nm.

3. A composition according to any preceding claim wherein the polymeric binder has a number average molecular weight of at least 2000.

4. A composition comprising a photocurable polymeric binder having a number average molecular weight of at least 2000, a first photosensitive component which is operative to undergo a Norrish type I reaction through homolytic alpha cleavage reaction between a carbonyl group and an adjacent carbon atom; and a second photosensitive component which is operative to undergo a Norrish type II reaction through hydrogen abstraction.

5. The composition of claim 3 or 4 wherein the first photosensitive system comprises a component which is operative to undergo a Norrish type I reaction through homolytic alpha cleavage reaction between a carbonyl group and an adjacent carbon atom, preferably a benzoin alkyl ether carbonyl compound, more preferably 2,2-dimethoxy-2-phenyl-acetophenone and the second photosensitive system comprises an amine compound, preferably a tertiary amine, more preferably diethylaminoethyl methacrylate, and a component which is operative to undergo a Norrish type II reaction through hydrogen abstraction, preferably benzophenone photoinitiator from the amine compound upon exposure to radiation having wavelengths in the range of 200-300 nm, more preferably a benzophenone which has the formula O=C(R)₂ where R is an unsubstituted phenyl ring.

6. A composition according to any preceding claim which is developable after curing by aqueous developer, and which is preferably provided as a layer, more preferably in a printing plate precursor.

7. A composition according to any of claims 4-6 wherein the polymeric binder comprises a prepolymer, containing groups which polymerise upon photoactivation of the first photosensitive system, the composition preferably comprising copolymerisable comonomer which copolymerises with the prepolymer upon photoactivation of the first photo sensitive system.

8. A composition according to claim 7 wherein the prepolymer is a urethane prepolymer having ethylenically unsaturated polymerisable groups.

9. A method for surface detackification of a polymeric composition, comprising the steps of:
providing a cured polymeric article having had incorporated, prior to curing thereof, a photoactivatable photosensitive component operative to reduce surface tack of said cured article when exposed to radiation having wavelengths in the range of 200-300 nm; and
exposing the surface of said cured polymeric article to radiation having wavelengths in the range 200 to 300 nm.

10. A method according to claim 9 wherein the step of providing a cured polymeric article comprises the steps of
combining into a homogenous mixture a photocurable polymeric binder, a first photosensitive system and a second photosensitive system homogenously first and second photosensitive systems comprising photoinitiators which are operative the first and second photosensitive systems having ultraviolet (UV) radiation absorption spectrums which are such that the two systems can be selectively photoactivated by using different UV radiation wavelengths; and
curing the mixture by exposing the mixture to radiation to activate the first photosensitive system.

11. A method according to claim 10 in which a layer of the homogeneous mixture is imagewise exposed to radiation to cure portions of the mixture and in which the uncured portions of the mixture are subsequently removed by a developer.

12. A method in which a photocurable composition comprising:
a photocurable polymeric binder, a first photosensitive system homogenously mixed with the binder, and a second photosensitive system homogenously mixed with the binder; the first and second photosensitive systems having ultraviolet (UV) radiation absorption spectrums which are such that the two systems can be selectively photoactivated by using different UV radiation wavelengths
is imagewise exposed to radiation to activate said first photosensitive system;
uncured composition is removed by treatment with a developer; and
the surface of the cured polymeric article is exposed to radiation having wavelengths in the range 200 to 300 nm to activate said second photosensitive system.

13. A method according to claim 11 or 13 in which the developer is an aqueous developer.

14. A method according to any of claims 10 to 12 in which the radiation used to activate the first photosensitive system has wavelength of at least 300 nm.

15. A method according to any of claims 9 to 14 in which surface of the cured polymeric article is, prior to the exposure by radiation having wavelength in the range 200 to 300 nm, contacted with an aqueous composition.

16. A method according to claim 15 in which, after said contacting step and prior to exposing the cured surface to radiation of wavelength 200 to 300 nm, the article is treated to remove water from its surface.

17. The method of claim 16 wherein said step of removing water from the surface of said cured polymeric article comprises the step of drying the surface with paper.

18. A method according to any of claims 9 to 17 having the further features of any of claims 3 to 8.

19. A polymeric article having a detackified surface produced by a method according to any of claims 9 to 18 which is non-tacky after being contacted with isopropanol.

20. A relief printing plate produced by a method according to any of claims 9 to 18.
